# EUROPÄISCHE PATENTSCHRIFT

(11) **EP 1 597 779 B1**
(45) Veröffentlichungstag und Bekanntmachung des Hinweises auf die Patenterteilung: **06.09.2006**
(21) Anmeldenummer: 04791198.7
(22) Anmeldetag: 12.10.2004
(51) Int. Cl.: H01L 41/053, H01L 41/083, F02M 51/06

(54) **AUFNAHMEHÜLSE FÜR EINEN PIEZOAKTOR**
RECEIVING SLEEVE FOR A PIEZOELECTRIC ACTUATOR
DOUILLE DE RECEPTION POUR ACTIONNEUR PIEZOELECTRIQUE

(30) Priorität: 14.10.2003 DE 10347770
(43) Veröffentlichungstag der Anmeldung: 23.11.2005
(73) Patentinhaber: SIEMENS AKTIENGESELLSCHAFT, 80333 München (DE)
(72) Erfinder: DÖLLGAST, Bernd, 91054 Erlangen (DE); GILG, Horst, 93142 Maxhütte (DE); HAUBOLD, Jörg, 09247 Kändler (DE); SANFTLEBEN, Emanuel, 93102 Geisling (DE); SCHUH, Carsten, 85598 Baldham (DE); ZUMSTRULL, Claus, 93128 Regenstauf (DE)
(86) Internationale Anmeldenummer: PCT/EP2004/052505
(87) Internationale Veröffentlichungsnummer: WO 2005/036663

(56) Entgegenhaltungen:
- WO-A-99/08330
- WO-A-20/04004021
- DE-A- 19 939 132
- DE-C- 19 844 742

## Beschreibung

Die Erfindung betrifft eine Aufnahmehülse für einen Piezoaktor, insbesondere für einen Piezoaktor zum Antrieb eines Injektors einer Einspritzanlage für eine Brennkraftmaschine, gemäß dem Oberbegriff des Anspruchs 1.

Eine derartige Aufnahmehülse ist aus der Druckschrift WO 2004/004021 A (Veröffentlichangsdatum 08.01.2004) bekannt.

In modernen Einspritzanlagen für Brennkraftmaschinen werden zum Antrieb der Injektoren zunehmend Piezoaktoren eingesetzt. Bei der Montage derartiger Piezoaktoren wird herkömmlicherweise ein piezokeramischer Stapel in eine zylindrische Aufnahmehülse eingebaut, die aus zwei zylindrischen Hülsenteilen besteht. In den Stirnflächen der beiden zylindrischen Hülsenteile sind hierbei Aussparungen angeordnet, durch die der piezokeramische Stapel nach außen ragt, wobei die Aufnahmehülse etwas kürzer als der piezokeramische Stapel ist, so dass der Kraftschluss nur über die Stirnflächen des piezokeramischen Stapels erfolgt.

Beim Zusammenbau dieser bekannten Aufnahmehülse muss darauf geachtet werden, dass der piezokeramische Stapel genau in die zugehörigen Aussparungen in den beiden zylindrischen Hülsenteilen trifft. Dazu wird der piezokeramische Stapel zunächst so in eines der beiden Hülsenteile eingesetzt, dass die Aussparung in dem Hülsenteil den piezokeramischen Stapel aufnimmt. Anschließend wird dann das zweite Hülsenteil aufgesetzt und auf das andere Hülsenteil aufgedrückt, bis die beiden Hülsenteile durch eine Rastverbindung miteinander verbunden sind. Bei dieser Montage muss darauf geachtet werden, dass die beiden Hülsenteile eine vorgegebene Winkellage relativ zueinander einhalten, damit die Aussparungen in den Stirnflächen der beiden Hülsenteile in Deckung übereinander liegen, so dass diese den piezokeramischen Stapel aufnehmen. Bei einem Winkelversatz zwischen den beiden Hülsenteilen während der Montage liegen die Aussparungen für den piezokeramischen Stapel dagegen nicht in Deckung übereinander, so dass die Aufnahmehülse nicht zusammengesteckt werden kann.

Nachteilig an der bekannten Aufnahmehülse ist also die aufwendige Montage.

Der Erfindung liegt deshalb die Aufgabe zugrunde, eine Aufnahmehülse für einen Piezoaktor zu schaffen, die eine Montage mit einem geringen Aufwand ermöglicht.

Diese Aufgabe wird, ausgehend von der eingangs beschriebenen bekannten Aufnahmehülse gemäß dem Oberbegriff des Anspruchs 1, durch die kennzeichnenden Merkmale des Anspruchs 1 gelöst.

Die Erfindung umfasst die allgemeine technische Lehre, eine Verdrehsicherung vorzusehen, damit die beiden Hülsenteile der Aufnahmehülse relativ zueinander eine vorgegebene Winkellage einhalten, welche die Montage ermöglicht.

Eine derartige Verdrehsicherung bietet den Vorteil, dass bei der Montage der erfindungsgemäßen Aufnahmehülse nicht auf die exakte Winkelausrichtung der beiden Hülsenteile geachtet werden muss, da diese durch die Verdrehsicherung sichergestellt wird.

In einem bevorzugten Ausführungsbeispiel der Erfindung weist die Verdrehsicherung eine Nut-Feder-Verbindung auf, die aus einer an einem der beiden Hülsenteile angebrachten Nut und einer an dem anderen Hülsenteil angebrachten, formangepassten Feder besteht, die im montierten Zustand in die Nut eingreift. Die Verdrehsicherung kann auch mehrere Nuten und Federn aufweisen, die über den Umfang der Hülsenteile verteilt angeordnet sind und jeweils paarweise ineinander eingreifen, um eine vorgegebene Winkellage zwischen den beiden Hülsenteilen einzuhalten.

Vorzugsweise weist die Nut und/oder die Feder einer derartigen Verdrehsicherung eine Einlaufschräge auf, welche die Montage der erfindungsgemäßen Aufnahmehülse erleichtert, indem die Einlaufschräge eine Vormontage der beiden Hülsenteile auch mit einem Winkelversatz ermöglicht, der dann bei der Montage durch die Einlaufschräge ausgeglichen wird. Der maximal zulässige Winkelversatz zwischen den beiden Hülsenteilen kann hierbei im Bereich zwischen 1° und 10° liegen, was die Montage der erfindungsgemäßen Aufnahmehülse wesentlich erleichtert, da die Anforderungen an die Winkelausrichtung der beiden Hülsenteile verringert werden.

Im montierten Zustand der erfindungsgemäßen Aufnahmehülse sind die einzelnen Hülsenteile vorzugsweise durch eine Steckverbindung miteinander verbunden, wobei die Steckverbindung eine konstruktionsbedingt vorgegebene Steckverbindungslänge aufweist. Als Steckverbindungslänge ist hierbei der Weg zu verstehen, um den die beiden Hülsenteile relativ zueinander bewegt werden müssen, um von einem völlig getrennten Zustand in den montierten Zustand überzugehen. Bei einer derartigen Steckverbindung ist es vorteilhaft, wenn sich die Einführschräge der Nut bzw. Feder in Axialrichtung der Hülsenteile nur über einen Teil der Steckverbindungslänge erstreckt, während der restliche Teil der Steckverbindungslänge von der Verdrehsicherung eingenommen werden kann. Würde sich die Einführschräge nämlich über die gesamte Steckverbindungslänge erstrecken, so würde die Verdrehsicherung nur dann wirken, wenn die beiden Hülsenteile vollständig zusammengesteckt sind. Falls sich die Einführschräge dagegen nur über einen Bruchteil der Steckverbindungslänge erstrecken würde, so müsste der zwischen den beiden Hülsenteilen bei der Vormontage zunächst auftretende Winkelversatz auf einer sehr kurzen Aufstecklänge ausgeglichen werden, was mechanisch nachteilig ist. Bei der erfindungsgemäßen Aufnahmehülse erstreckt sich die Einlaufschräge deshalb vorzugsweise über 10% bis 50% der gesamten Steckverbindungslänge, was einen guten Kompromiss zwischen einer sicheren Wirkung der Verdrehsicherung einerseits und einem guten Ausgleich des Winkelversatzes zwischen den zu montierenden Hülsenteilen darstellt.

Weiterhin ist zu erwähnen, dass sich die Nut und/oder die Feder der Verdrehsicherung vorzugsweise von dem jeweils freien Ende des jeweiligen Hülsenteils ausgehend mindestens über einen Teil der Steckverbindungslänge erstreckt, so dass die Feder bereits während des Zusammensteckens der beiden Hülsenteile und nicht erst im vollständig zusammengesteckten Zustand in die zugehörige Nut eingreift.

Darüber hinaus ist es vorteilhaft, wenn sich die Nut und/oder die Feder der Nut-Feder-Verbindung über die gesamte Steckverbindungslänge der Steckverbindung erstreckt, wobei die Einlaufschräge nur einen Teil der Steckverbindungslänge einnimmt, während die Verdrehsicherung den gesamten Rest der Steckverbindungslänge einnimmt. Die Nut-Feder-Verbindung wirkt hierbei also auf einem Teil der Steckverbindungslänge als Verdrehsicherung und auf dem anderen Teil der Steckverbindungslänge als Montagehilfe zum Ausgleich eines Winkelversatzes zwischen den zu montierenden Hülsenteilen.

Besonders vorteilhaft ist es, wenn bei der Nut-Feder-Verbindung sowohl die Nut als auch die Feder eine Einlaufschräge aufweist, so dass die Einlaufschrägen von Nut und Feder paarweise aufeinander gleiten, so dass ein Winkelversatz zwischen den zu montierenden Hülsenteilen bei geringen mechanischen Belastungen ausgeglichen wird. Vorzugsweise weist die Einlaufschräge der Nut hierbei im Wesentlichen den gleichen Einlaufwinkel auf wie die Einlaufschräge der Feder, so dass die beiden Einlaufschrägen bei der Montage im Wesentlichen planparallel und damit verschleißarm aufeinander gleiten.

Die Verbindung der beiden Hülsenteile erfolgt im montierten Zustand vorzugsweise durch eine herkömmliche Rastverbindung, jedoch sind grundsätzlich auch andere form- und kraftschlüssige Verbindungen zwischen den zu montierenden Hülsenteilen möglich.

Bei einer Verwendung einer Rastverbindung ist es vorteilhaft, wenn die Einlaufschräge beim Zusammenstecken der beiden Hülsenteile nur bis zu dem Rastpunkt wirkt, wohingegen nach dem Überschreiten des Rastpunktes der Rastverbindung ausschließlich eine Verdrehsicherung besteht. Ein möglicher Winkelversatz zwischen den zu montierenden Hülsenteilen wird hierbei also ausgeglichen, bevor der Rastpunkt der Rastverbindung überschritten wird.

Hinsichtlich der Gestaltung der Einlaufschräge bestehen vielfältige Möglichkeiten, jedoch ist die Einlaufschräge bei dem bevorzugten Ausführungsbeispiel im Wesentlichen gerade und ungekrümmt. Es ist jedoch im Rahmen der Erfindung auch möglich, dass die Einlaufschräge beispielsweise einen gekrümmten, kurvenförmigen Verlauf aufweist.

Darüber hinaus ist zu erwähnen, dass die Einlaufschräge bei dem bevorzugten Ausführungsbeispiel übergangslos in die Verdrehsicherung übergeht. Beispielsweise kann die Einlaufschräge mit einem Knick in die Verdrehsicherung übergehen, jedoch ist es auch möglich, dass die Einlaufschräge knickfrei in die Verdrehsicherung übergeht.

Bei der Beschreibung des Standes der Technik wurde eingangs bereits erwähnt, dass die beiden Hülsenteile in ihren Stirnflächen jeweils Aussparungen zur Führung des Piezoaktors aufweisen, was vorzugsweise auch bei der erfindungsgemäßen Aufnahmehülse der Fall ist.

Im montierten Zustand ragt der Piezoaktor durch diese Aussparungen aus der erfindungsgemäßen Aufnahmehülse nach außen, wobei der Piezoaktor mit den Aussparungen vorzugsweise eine Passung bildet, deren Winkelspiel größer ist als das Winkelspiel der Verdrehsicherung, um zu verhindern, dass die erfindungsgemäße Aufnahmehülse Torsionskräfte auf den Piezoaktor ausübt.

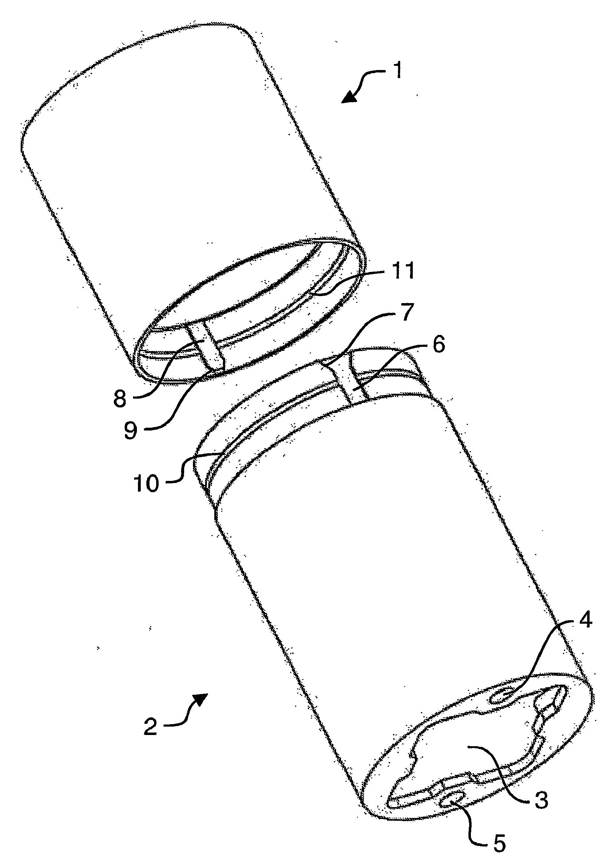

Andere vorteilhafte Weiterbildungen der Erfindung sind in den Unteransprüchen gekennzeichnet oder werden nachstehend zusammen mit der Beschreibung des bevorzugten Ausführungsbeispiels der Erfindung anhand der Figur näher erläutert. So zeigt die einzige Figur 1 eine Perspektivansicht einer erfindungsgemäßen Aufnahmehülse für einen Piezoaktor zum Antrieb eines Injektors einer Einspritzanlage für eine Brennkraftmaschine, wobei der Piezoaktor zur Vereinfachung nicht dargestellt ist.

Die Aufnahmehülse besteht im Wesentlichen aus zwei zylindrischen Hülsenteilen 1, 2, in deren Stirnflächen jeweils eine Aussparung 3 zur Führung des Piezoaktors angeordnet ist, wobei die in dem Hülsenteil 1 angeordnete Aussparung in der Zeichnung verdeckt ist.

Darüber hinaus sind in den Stirnflächen der beiden Hülsenteile 1, 2 jeweils zwei kreisförmige Bohrungen 4, 5 angeordnet, die in den jeweiligen Stirnflächen auf gegenüberliegenden Seiten angeordnet sind und eine Durchführung von Anschlusspins des Piezoaktors ermöglichen. Die in dem Hülsenteil 1 angeordneten Bohrungen sind hierbei ebenfalls verdeckt.

Bei der Montage der Aufnahmehülse wird zunächst der Piezo-Stack in das Hülsenteil 2 eingesetzt, bis der Piezo-Stack durch die Aussparung 3 nach außen hindurchragt, wobei die Aussparung 3 den Piezo-Stack mechanisch führt. Die Anschlusspins des Piezo-Stacks ragen dann durch die Bohrungen 4, 5 in dem Hülsenteil 2 nach außen, was eine elektrische Kontaktierung des Piezo-Stacks ermöglicht.

Anschließend wird dann das Hülsenteil 1 so auf das Hülsenteil 2 aufgesteckt, dass die Aussparung 3 in dem Hülsenteil 2 ungefähr in Deckung unter der entsprechenden Aussparung in der Stirnfläche des Hülsenteils 1 liegt.

Zur Erleichterung dieser Montage sind in der äußeren Mantelfläche des Hülsenteils 2 auf gegenüberliegenden Seiten zwei axial verlaufende Nuten 6 angeordnet, deren Nutbreite sich zu dem freien Ende des Hülsenteils 2 hin in Richtung auf das andere Hülsenteil 1 in Form einer Einlaufschräge 7 erweitert.

In der inneren Mantelfläche des anderen Hülsenteils 1 sind auf gegenüberliegenden Seiten zwei entsprechend formangepasste Federn 8 angeordnet, deren Breite sich zu dem freien Ende des Hülsenteils 1 hin in Richtung auf das andere Hülsenteil 2 in Form einer Einlaufschräge 9 verringert :

Beim Aufstecken des Hülsenteils 1 auf das Hülsenteil 2 ist also vorteilhafterweise keine exakte Winkelausrichtung der beiden Hülsenteile 1, 2 relativ zueinander erforderlich, da ein Winkelversatz durch die Einlaufschrägen 7, 9 ausgeglichen wird.

Die Einlaufschrägen 7 der Nuten 6 weisen hierbei den gleichen Einlaufwinkel auf wie die Einlaufschrägen 9 der Federn 8, so dass die Einlaufschrägen 7, 9 bei der Montage planparallel und damit verschleißarm aufeinander gleiten.

Im montierten Zustand sind die beiden Hülsenteile 1, 2 dann durch eine Rastverbindung miteinander verbunden, die aus einer umlaufenden Nut 10 in dem Hülsenteil 2 und einem entsprechenden umlaufenden Rastvorsprung 11 in der inneren Mantelfläche des Hülsenteils 1 besteht.

Weiterhin ist zu erwähnen, dass sich die Einlaufschrägen 7, 9 nur über einen Teil von ungefähr 30% der Steckverbindungslänge erstrecken, während die Nut-Feder-Verbindung zwischen der Nut 6 und der Feder 8 auf dem restlichen Teil der Steckverbindungslänge ausschließlich der Verdrehsicherung dient. Auf diese Weise wirkt die Verdrehsicherung bereits dann, wenn der Rastpunkt der Rastverbindung bei der Montage überschritten ist.

Weiterhin ist zu erwähnen, dass die Aussparungen 3 in den Stirnflächen der Hülsenteile 1, 2 eine Passung mit dem Piezo-Stack bilden, deren Winkelspiel größer ist als das Winkelspiel der durch die Nut-Feder-Verbindung gebildeten Verdrehsicherung. Dadurch wird sichergestellt, dass die Hülsenteile 1, 2 im montierten Zustand keine Torsionskraft auf den Piezo-Stack ausüben.

Die Erfindung ist nicht auf das vorstehend beschriebene bevorzugte Ausführungsbeispiel beschränkt. Vielmehr ist eine Vielzahl von Varianten und Abwandlungen möglich, die ebenfalls von dem Erfindungsgedanken Gebrauch machen und deshalb in den Schutzbereich der Patenansprüche fallen.

## Patentansprüche

1. Aufnahmehülse für einen Piezoaktor, insbesondere für einen Piezoaktor zum Antrieb eines Injektors einer Einspritzanlage für eine Brennkraftmaschine, mit
einem ersten Hülsenteil (1) und einem zweiten Hülsenteil (2),
wobei das erste Hülsenteil (1) im montierten Zustand mit dem zweiten Hülsenteil (2) verbunden ist,
**gekennzeichnet durch**
eine Verdrehsicherung (6, 8) zur Einhaltung einer vorgegebenen Winkellage zwischen dem ersten Hülsenteil (1) und dem zweiten Hülsenteil (2).

2. Aufnahmehülse nach Anspruch 1,
**dadurch gekennzeichnet,**
**dass** die Verdrehsicherung (6, 8) eine Nut-Feder-Verbindung aufweist, die aus einer an einem der beiden Hülsenteile (1, 2) angebrachten Nut (6) und einer an dem anderen Hülsenteil (1) angebrachten, formangepassten Feder (8) besteht, die im montierten Zustand in die Nut (6) eingreift.

3. Aufnahmehülse nach Anspruch 2,
**dadurch gekennzeichnet,**
**dass** die Nut (6) und/oder die Feder (8) eine Einlaufschräge (7, 9) aufweist, wobei die Einlaufschräge (7, 9) eine Vormontage des ersten Hülsenteils (1) und des zweiten Hülsenteils (2) mit einem Winkelversatz ermöglicht.

4. Aufnahmehülse nach Anspruch 3,
**dadurch gekennzeichnet,**
**dass** der maximale Winkelversatz für die Vormontage im Bereich zwischen 1° und 10° liegt.

5. Aufnahmehülse nach Anspruch 3 oder 4,
**gekennzeichnet durch**
eine Steckverbindung zwischen dem ersten Hülsenteil (1) und dem zweiten Hülsenteil (2) mit einer vorgegebenen Steckverbindungslänge, wobei sich die Einlaufschräge (7, 9) in Axialrichtung nur über einen Teil der Steckverbindungslänge erstreckt.

6. Aufnahmehülse nach Anspruch 5,
**dadurch gekennzeichnet,**
**dass** sich die Einlaufschräge (7, 9) in Axialrichtung über 10% bis 50% der Steckverbindungslänge erstreckt.

7. Aufnahmehülse nach Anspruch 5 oder 6,
**dadurch gekennzeichnet,**
**dass** sich die Nut (6) und/oder die Feder (8) von dem jeweils freien Ende des jeweiligen Hülsenteils (1, 2) ausgehend mindestens über ein Teil der Steckverbindungslänge erstreckt, so dass die Feder (8) bereits während des Zusammensteckens der beiden Hülsenteile (1, 2) in die Nut (6) eingreift.

8. Aufnahmehülse nach einem der Ansprüche 5 bis 7,
**dadurch gekennzeichnet,**
**dass** sich die Nut (6) und/oder die Feder (8) der Nut-Feder-Verbindung (6, 8) über die gesamte Steckverbindungslänge erstreckt, wobei die Einlaufschräge (7, 9) einen Teil der Steckverbindungslänge einnimmt, während die Verdrehsicherung den gesamten Rest der Steckverbindungslänge einnimmt.

9. Aufnahmehülse nach einem der Ansprüche 3 bis 8,
**dadurch gekennzeichnet,**
**dass** sowohl die Nut (6) als auch die Feder (8) eine Einlaufschräge (7, 9) aufweist.

10. Aufnahmehülse nach Anspruch 9,
**dadurch gekennzeichnet,**
**dass** die Einlaufschräge (7) der Nut (6) im wesentlichen den gleichen Einlaufwinkel aufweist wie die Einlaufschräge (9) der Feder (8), so dass die beiden Einlaufschrägen (7, 9) bei der Montage im wesentlichen planparallel aufeinander gleiten.

11. Aufnahmehülse nach einem der vorhergehenden Ansprüche,
**dadurch gekennzeichnet,**
**dass** das erste Hülsenteil (1) im montierten Zustand mit dem zweiten Hülsenteil (2) durch eine Rastverbindung (10, 11) verbunden ist, die einen vorgegebenen Rastpunkt aufweist.

12. Aufnahmehülse nach Anspruch 11,
**dadurch gekennzeichnet,**
**dass** die Einlaufschräge (7, 9) beim Zusammenstecken der beiden Hülsenteile (1, 2) nur maximal bis zu dem Rastpunkt wirkt.

13. Aufnahmehülse nach einem der Ansprüche 3 bis 12,
**dadurch gekennzeichnet,**
**dass** die Einlaufschräge (7, 9) im wesentlichen gerade und ungekrümmt verläuft.

14. Aufnahmehülse nach einem der Ansprüche 3 bis 13,
**dadurch gekennzeichnet,**
**dass** die Einlaufschräge (7, 9) übergangslos in die Verdrehsicherung übergeht.

15. Aufnahmehülse nach einem der Ansprüche 3 bis 14,
**dadurch gekennzeichnet,**
**dass** die Einlaufschräge (7, 9) mit einem Knick in die Verdrehsicherung übergeht.

16. Aufnahmehülse nach einem der vorhergehenden Ansprüche,
**dadurch gekennzeichnet,**
**dass** das erste Hülsenteil (1) und das zweite Hülsenteil (2) jeweils in ihren Stirnflächen Aussparungen (3-5) zur Führung des Piezoaktors aufweisen.

17. Aufnahmehülse nach Anspruch 16 mit einem Piezoaktor,
**dadurch gekennzeichnet,**
**dass** der Piezoaktor mit den Aussparungen (3-5) eine Passung bildet, deren Winkelspiel größer ist, als das Winkelspiel der Verdrehsicherung, um Torsionskräfte auf den Piezoaktor zu verhindern.

18. Piezoaktor mit elektrischen Anschlüssen und einer Aufnahmehülse nach einem vorhergehenden Ansprüche,
**dadurch gekennzeichnet,**
**dass** der Piezoaktor von der Aufnahmehülse (1, 2) längsseitig umfasst ist.

## Claims

1. Receiving sleeve for a piezoelectric actuator, in particular for a piezoelectric actuator for driving an injector of an injection system for an internal combustion engine, having
a first sleeve part (1) and a second sleeve part (2),
the first sleeve part (1) being connected to the second sleeve part (2) in the assembled state,
**characterised by**
an anti-rotation element (6, 8) for maintaining a predetermined angular position between the first sleeve part (1) and the second sleeve part (2).

2. Receiving sleeve according to claim 1,
**characterised in that**
the anti-rotation element (6, 8) has a slot-and-key connection which consists of a slot (6) that is incorporated in one of the two sleeve parts (1, 2) and a shape-matched key (8) that is attached to the other sleeve part (1) and in the assembled state engages in the slot (6).

3. Receiving sleeve according to claim 2,
**characterised in that**
the slot (6) and/or the key (8) have/has an insertion bevel (7, 9), the insertion bevel (7, 9) enabling a pre-assembly of the first sleeve part (1) and the second sleeve part (2) with an angular displacement.

4. Receiving sleeve according to claim 3,
**characterised in that**
the maximum angular displacement for the pre-assembly lies in the range between 1° and 10°.

5. Receiving sleeve according to claim 3 or 4,
**characterised by**
a plug-and-socket connection between the first sleeve part (1) and the second sleeve part (2) having a predetermined length, the insertion bevel (7, 9) extending in the axial direction over only a part of the length of the plug-and-socket connection.

6. Receiving sleeve according to claim 5,
**characterised in that**
the insertion bevel (7, 9) extends in the axial direction over 10% to 50% of the length of the plug-and-socket connection.

7. Receiving sleeve according to claim 5 or 6,
**characterised in that**
the slot (6) and/or key (8) extend/extends over at least a part of the length of the plug-and-socket connection, starting from the free end of the respective sleeve part (1, 2) in each case, so that the key (8) engages in the slot (6) already during the joining together of the two sleeve parts (1, 2).

8. Receiving sleeve according to one of the claims 5 to 7,
**characterised in that**
the slot (6) and/or key (8) of the slot-and-key connection (6, 8) extend/extends over the entire length of the plug-and-socket connection, the insertion bevel (7, 9) taking up a part of the length of the plug-and-socket connection, while the anti-rotation element takes up all of the remainder of the length of the plug-and-socket connection.

9. Receiving sleeve according to one of the claims 3 to 8,
**characterised in that**
both the slot (6) and the key (8) have an insertion bevel (7, 9).

10. Receiving sleeve according to claim 9,
**characterised in that**
the insertion bevel (7) of the slot (6) has essentially the same insertion angle as the insertion bevel (9) of the key (8), so that during assembly the two insertion bevels (7, 9) slide onto each other in essentially plane-parallel fashion.

11. Receiving sleeve according to one of the preceding claims,
**characterised in that**
in the assembled state the first sleeve part (1) is mated with the second sleeve part (2) by means of a snap-in connection (10, 11) which has a predetermined latching point.

12. Receiving sleeve according to claim 11,
**characterised in that**
the insertion bevel (7, 9) acts at a maximum only as far as the latching point when the two sleeve parts (1, 2) are joined together.

13. Receiving sleeve according to one of the claims 3 to 12,
**characterised in that**
the insertion bevel (7, 9) runs essentially straight and uncurved.

14. Receiving sleeve according to one of the claims 3 to 13,
**characterised in that**
the insertion bevel (7, 9) transitions seamlessly into the anti-rotation element.

15. Receiving sleeve according to one of the claims 3 to 14,
**characterised in that**
the insertion bevel (7, 9) transitions with a bend into the anti-rotation element.

16. Receiving sleeve according to one of the preceding claims,
**characterised in that**
the first sleeve part (1) and the second sleeve part (2) each have recesses (3-5) in their end faces for guiding the piezoelectric actuator.

17. Receiving sleeve according to claim 16 having a piezoelectric actuator,
**characterised in that**
the piezoelectric actuator with the recesses (3-5) forms a fit whose angular clearance is greater than the angular clearance of the anti-rotation element in order to prevent torsional forces being brought to bear on the piezoelectric actuator.

18. Piezoelectric actuator having electrical connecting leads and a receiving sleeve according to one of the preceding claims,
**characterised in that**
the piezoelectric actuator is enclosed on the longitudinal side by the receiving sleeve (1, 2).

## Revendications

1. Manchon de logement pour un actionneur piézoélectrique, en particulier pour un actionneur piézoélectrique destiné à l'entraînement d'un injecteur d'une installation d'injection pour un moteur à combustion interne, comprenant
un premier demi-manchon (1) et un deuxième demi-manchon (2),
le première demi-manchon (1) étant assemblé au deuxième demi-manchon (2) à l'état monté,
**caractérisé par**
un blocage anti-torsion (6, 8) destiné à maintenir une position angulaire prédéterminée entre le premier demi-manchon (1) et le deuxième demi-manchon (2).

2. Manchon de logement selon la revendication 1,
**caractérisé en ce que**
le blocage anti-torsion (6, 8) comprend un assemblage à rainure et languette qui est composé d'une rainure (6) ménagée sur un des demi-manchons (1, 2) et d'une languette (8) de forme adaptée prévue sur l'autre demi-manchon (1) et qui est engagée dans la rainure (6) à l'état monté.

3. Manchon de logement selon la revendication 2,
**caractérisé en ce que**
la rainure (6) et/ou la languette (8) présentent un chanfrein d'entrée (7, 9), le chanfrein d'entrée (7, 9) permettant d'exécuter un pré-montage du premier demi-manchon (1) et du deuxième demi-manchon (2) avec décalage angulaire.

4. Manchon de logement selon la revendication 3,
**caractérisé en ce que**
le décalage angulaire maximal pour le pré-montage est compris dans l'intervalle entre 1 ° et 10 °.

5. Manchon de logement selon la revendication 3 ou 4,
**caractérisé par**
un assemblage à emboîtement entre le premier demi-manchon (1) et le deuxième demi-manchon (2) comportant une longueur d'assemblage à emboîtement prédéterminée, le chanfrein d'entrée (7, 9) ne s'étendant que sur une partie de la longueur de l'assemblage à emboîtement dans la direction axiale.

6. Manchon de logement selon la revendication 5,
**caractérisé en ce que**
le chanfrein d'entrée (7, 9) s'étend sur 10 % à 50 % de la longueur de l'assemblage à emboîtement dans la direction axiale.

7. Manchon de logement selon la revendication 5 ou 6,
**caractérisé en ce que**,
la rainure (6) et/ou la languette (8) s'étendent chacune au moins sur une partie de la longueur de l'assemblage à emboîtement à partir de l'extrémité libre de leur demi-manchon (1, 2), de sorte que la languette (8) s'engage déjà dans la rainure (6) au cours de l'assemblage par emboîtement des deux demi-manchons (1, 2).

8. Manchon de logement selon une des revendications 5 à 7,
**caractérisé en ce que**
la rainure (6) et/ou la languette (8) de l'assemblage à rainure et languette (6, 8) s'étendent sur toute la longueur de l'assemblage à emboîtement, le chanfrein d'entrée (7, 9) occupant une partie de la longueur de l'assemblage à emboîtement, tandis que le blocage anti-torsion occupe tout le reste de la longueur de l'assemblage à emboîtement.

9. Manchon de logement selon une des revendications 3 à 8,
**caractérisé en ce que**
la rainure (6) aussi bien que la languette (8) présentent un chanfrein d'entrée (7, 9).

10. Manchon de logement selon la revendication 9,
**caractérisé en ce que**
le chanfrein d'entrée (7) de la rainure (6) présente sensiblement le même angle d'entrée que le chanfrein d'entrée (9) de la languette (8), de sorte que les deux chanfreins d'entrée (7, 9) glissent l'un sur l'autre dans des plans sensiblement parallèles au cours du montage.

11. Manchon de logement selon une des revendications précédentes,
**caractérisé en ce que**,
à l'état monté, le premier demi-manchon (1) est assemblé au deuxième demi-manchon (2) par un assemblage à enclenchement (10, 11) qui présente un point d'enclenchement prédéterminé.

12. Manchon de logement selon la revendication 11,
**caractérisé en ce que**
lors de l'emboîtement des deux demi-manchons (1, 2), le chanfrein d'entrée (7, 9) n'agit au maximum que jusqu'au point d'enclenchement.

13. Manchon de logement selon une des revendications 3 à 12,
**caractérisé en ce que**
le chanfrein d'enclenchement (7, 9) s'étend sensiblement en ligne droite ou sans courbure.

14. Manchon de logement selon une des revendications 3 à 13,
**caractérisé en ce que**
le chanfrein d'entrée (7, 9) se raccorde sans transition au blocage anti-torsion.

15. Manchon de logement selon une des revendications 3 à 14,
**caractérisé en ce que**
le chanfrein d'entrée (7, 9) se raccorde au blocage anti-torsion par une rupture de ligne.

16. Manchon de logement selon une des revendications précédentes,
**caractérisé en ce que**
le premier demi-manchon (1) et le deuxième demi-manchon (2) présentent dans leurs surfaces frontales respectives des évidements (3-5) pour le guidage de l'actionneur piézoélectrique.

17. Manchon de logement selon la revendication 16 avec un actionneur piézoélectrique,
**caractérisé en ce que**
l'actionneur piézoélectrique forme avec les évidements (3-5) un ajustement dont le jeu angulaire est plus grand que le jeu angulaire du blocage anti-torsion, afin d'éviter qu'il ne s'exerce des forces de torsion sur l'actionneur piézoélectrique.

18. Actionneur piézoélectrique muni de connexions électriques et d'un manchon de logement selon une des revendications précédentes,
**caractérisé en ce que**
l'actionneur piézoélectrique est entouré par le manchon de logement (1, 2) dans le sens de sa longueur.
